# DEMANDE DE BREVET EUROPEEN

(11) **EP 1 881 532 A2**
(43) Date de publication de la demande: **23.01.2008**
(21) Numéro de dépôt: 07013251.9
(22) Date de dépôt: 06.07.2007
(51) Int. Cl.: H01L 27/146

(54) **Procédé de fabrication d'un wafer de semi-conducteur comprenant un filtre optique intégré**

(30) Priorité: 19.07.2006 FR 0606562
(71) Demandeur: STMicroelectronics Rousset SAS, 13790 Rousset (FR)
(72) Inventeur: Hernandez, Caroline, 13860 Peyrolles (FR)
(74) Mandataire: Marchand, André

(57) **Abrégé**

La présente invention concerne un procédé de fabrication de microplaquettes de semi-conducteur (100) comprenant chacune un composant (10) implanté dans le semi-conducteur, comprenant une étape d'implantation collective de composants (10) sur une face avant d'un wafer de semi-conducteur (15') et une étape de fixation d'une plaque d'un matériau transparent (20') sur la face avant du wafer. Selon l'invention, l'étape de fixation de la plaque de matériau transparent (20') est précédée d'une étape de dépôt, sur la face avant du wafer, d'au moins une couche (31, 32, 33) de matériau polymère formant un filtre optique. Application notamment à la fabrication d'imageurs.

## Description

La présente invention concerne la fabrication d'un wafer de semi-conducteur couvert par une plaque de verre et notamment la fabrication d'un wafer comprenant des imageurs CMOS.

Les imageurs réalisés selon la technologie CMOS ("Complementary Metal Oxide Semiconductor") font l'objet d'un nombre croissant d'applications en raison de leur faible prix de revient comparativement aux imageurs CCD ("Charge Coupled Device"). De tels imageurs CMOS étaient initialement utilisés pour réaliser des capteurs d'image à faible résolution et de qualité médiocre (par exemple des caméras web). Aujourd'hui, après un important investissement en recherche et développement, les imageurs CMOS peuvent rivaliser avec les imageurs CCD. La présente invention s'inscrit dans un effort de développement et de perfectionnement de cette technologie d'imageurs visant une baisse des prix de revient à qualité d'image au moins égale.

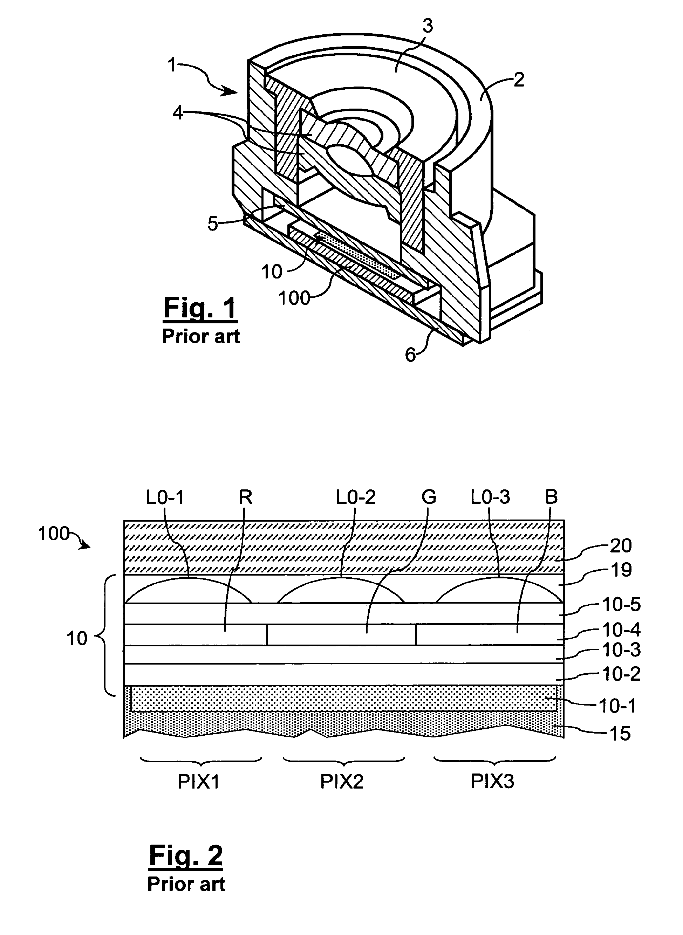

La figure 1 représente un exemple de module de capture d'images et/ou de capture vidéo utilisant un imageur CMOS, destiné par exemple à être monté dans un appareil portatif tel un téléphone mobile, un appareil photographique ou une caméra vidéo. Le module 1 comprend un châssis 2, un bloc optique 3, des lentilles 4 solidaires du bloc 3, un filtre optique 5 et un support 6. Une microplaquette de semi-conducteur 100 intégrant un imageur CMOS 10, est disposée sur le support 6 et reçoit la lumière passant à travers les lentilles 4 et le filtre 5. Le filtre 5 est généralement un filtre infrarouge (applications grand public) mais peut être aussi un filtre spécifique pour des applications industrielles nécessitant de capter des images dans une certaine gamme de fréquences ou de rejeter certaines gammes de fréquences.

L'imageur CMOS 10 comprend des photosites formant chacun un pixel (non visibles sur la figure 1). Chaque pixel comprend une photodiode et un circuit de contrôle et d'interconnexion de la photodiode. Les pixels sont agencés de façon matricielle et une mosaïque de filtres rouges, verts, bleus est répartie au-dessus de la matrice de pixels, généralement selon l'architecture de Bayer.

La figure 2 est une vue en coupe schématique de la microplaquette 100 et de l'imageur 10 dans une région correspondant à trois pixels PIX1, PIX2, PIX3. On distingue un substrat semi-conducteur 15 dans lequel l'imageur 10 est implanté, et une microplaquette de verre 20 fixée sur l'imageur par l'intermédiaire d'une couche de colle 19.

En allant du bas vers le haut, l'imageur 10 comprend des couches 10-1, 10-2, 10-3, 10-4, 10-5 et des microlentilles L0 (L0-1, L0-2, L0-3). La couche 10-1 représente la partie active de l'imageur et comprend des photodiodes et leurs circuits de contrôle et d'interconnexion associés (non détaillés). La couche 10-2 est un matériau diélectrique qui recouvre entièrement le substrat 15. La couche 10-3 est une couche de passivation déposée sur l'imageur en fin de processus de fabrication. La couche 10-4 est formée par des résines colorées et comprend des secteurs R, G, B de couleur rouge, verte ou bleue formant les filtres de couleur primaire susmentionnés, à raison d'un filtre de couleur par pixel. La couche 10-5 est une couche de résine intermédiaire formant un support pour les microlentilles L0 et offrant une bonne planéité (couche de "planarisation"). Les microlentilles L0 sont agencées en une matrice "MLA" (Microlens Array) à raison d'une microlentille par pixel, et sont recouvertes par la couche de colle 19 et par la microplaquette de verre 20.

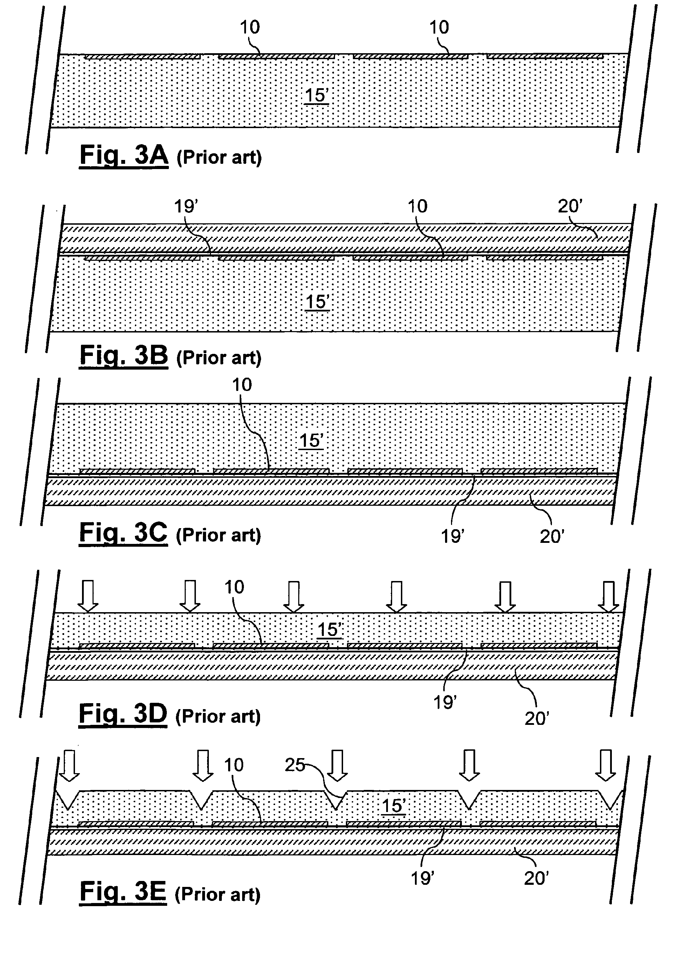

Des étapes d'un procédé de fabrication classique de la microplaquette d'imageur 100 sont représentées sur les figures 3A à 3E. Le procédé comprend tout d'abord la fabrication collective d'une pluralité d'imageurs 10 sur un wafer de silicium 15', comme représenté sur la figure 3A. A l'étape illustrée sur la figure 3B, une plaque de verre 20' est fixée sur la face avant du wafer 15' par l'intermédiaire d'une couche de colle 19' recouvrant tout le wafer, la colle comprenant par exemple de l'époxy, de l'uréthane, du silicone.... A l'étape de la figure 3C, le wafer 15' est retourné et est posé sur un support (non représenté) pour effectuer un traitement de sa face arrière. Ce traitement en face arrière comprend au moins une étape d'amincissement du wafer, une étape de gravure et une étape de sciage du wafer pour obtenir une pluralité de microplaquettes d'imageur comme la microplaquette 100.

L'étape d'amincissement, représentée sur la figure 3D, est généralement effectuée par abrasion mécanique (backlapping), et comprend le meulage et le polissage de la face arrière. L'épaisseur du wafer, initialement de l'ordre de quelques centaines de micromètres est de l'ordre de quelques dizaines ou d'une centaine de micromètres en fin de processus.

L'étape de gravure, représentée sur la figure 3E, permet d'obtenir des rainures ou sillons 25 ("grooves") sur la face arrière du wafer. Ces sillons peuvent être prévus pour diverses raisons, par exemple pour faciliter la découpe ultérieure du wafer ou pour réaliser des contacts sur la face arrière. Les sillons 25 sont généralement réalisés par gravure chimique ou gravure au plasma.

Un micromodule de capture d'image tel que représenté sur la figure 1 présente l'inconvénient d'être d'une structure relativement complexe et de nécessiter un temps d'assemblage non négligeable, grevant sont prix de revient.

En particulier, le filtre 5 est un composant additionnel d'un prix de revient élevé et nécessite une ligne de fabrication dédiée, puis des étapes de stockage, de manutention et d'assemblage.

Ainsi, un objectif de la présente invention est de prévoir un filtre qui soit moins coûteux à réaliser et plus simple à assembler que le filtre classique précédemment décrit.

Pour atteindre cet objectif, la présente invention se base sur l'idée simple mais non moins inventive d'ajouter à la surface du wafer fini tel que représenté en figure 3A, avant ou au moment de la fixation de la plaque de verre 20' (figure 3B), des couches de matériau polymère ayant des indices optiques différents afin de réaliser une fonction de filtrage, par exemple de filtrage infrarouge.

De cette manière, le filtre 5 dans le micromodule représenté en figure 1 n'est plus nécessaire.

Plus particulièrement, la présente invention prévoit un procédé de fabrication de microplaquettes de semi-conducteur comprenant chacune au moins un composant implanté dans le semi-conducteur, le procédé comprenant une étape d'implantation collective de composants sur une face avant d'un wafer de semi-conducteur, une étape de fixation d'une plaque d'un matériau transparent sur la face avant du wafer, dans lequel l'étape de fixation de la plaque de matériau transparent est précédée d'une étape de dépôt, sur la face avant du wafer, d'au moins une couche d'un matériau polymère formant un filtre optique.

Selon un mode de réalisation, l'étape de fixation de la plaque de matériau transparent est précédée d'une étape de dépôt, sur la face avant du wafer, de plusieurs couches de matériau(x) polymère(s) formant ensemble un filtre optique multicouche.

Selon un mode de réalisation, au moins la dernière couche du filtre est une couche de colle assurant la fixation de la plaque de matériau transparent.

Selon un mode de réalisation, toute couche formant le filtre est une couche de colle.

Selon un mode de réalisation, le procédé comprend une étape consistant à recouvrir le filtre optique par une couche de colle assurant la fixation de la plaque de matériau transparent et n'intervenant pas dans la fonction de filtrage optique.

Selon un mode de réalisation, le matériau polymère de chaque couche du filtre est choisi dans le groupe comprenant les résines photosensibles, les résines planarisantes et les colles.

Selon un mode de réalisation, chaque couche du filtre est polymérisée avant le dépôt de la couche suivante.

Selon un mode de réalisation, au moins une couche du filtre n'est pas polymérisée avant le dépôt de la couche suivante, laquelle est miscible avec la couche non polymérisée, de manière à former une couche résultante à variation progressive d'indice optique qui est ensuite polymérisée.

Selon un mode de réalisation, au moins une couche du filtre optique est déposée par enduction centrifuge.

Selon un mode de réalisation, le procédé comprend une étape de découpe du wafer en microplaquettes individuelles.

Selon un mode de réalisation, l'étape d'implantation de composants sur une face du wafer comprend l'implantation d'imageurs destinés à capter des images par l'intermédiaire de la plaque de matériau transparent et du filtre optique.

Selon un mode de réalisation, la plaque de matériau transparent est en verre.

La présente invention concerne également un imageur implanté sur une microplaquette de semi-conducteur, comprenant une microplaquette de matériau transparent solidaire de la microplaquette de semi-conducteur, par l'intermédiaire de laquelle l'imageur reçoit des images à capter, et comprenant, entre la microplaquette de semi-conducteur et la microplaquette de matériau transparent, au moins une couche de matériau polymère formant un filtre optique.

Selon un mode de réalisation, l'imageur comprend entre la microplaquette de semi-conducteur et la microplaquette de matériau transparent plusieurs couches de matériau(x) polymère(s) formant ensemble un filtre optique multicouche.

Selon un mode de réalisation, le filtre optique est recouvert par une couche de colle assurant la fixation de la plaque de matériau transparent et n'intervenant pas dans la fonction de filtrage optique.

Selon un mode de réalisation, la dernière couche de matériau polymère du filtre optique est une couche de colle assurant la fixation de la plaque de matériau transparent.

Selon un mode de réalisation, toute couche de matériau polymère formant le filtre optique multicouche est une couche de colle.

Selon un mode de réalisation, toute couche du filtre optique est formée par un matériau appartenant au groupe comprenant les résines photosensibles, les résines planarisantes et les colles.

Selon un mode de réalisation, le filtre optique présente une graduation d'indice optique.

Selon un mode de réalisation, le filtre optique multicouche présente une variation progressive d'indice optique.

Selon un mode de réalisation, la microplaquette de matériau transparent est en verre.

La présente invention concerne également un appareil portatif comprenant un module photographique ou vidéo équipé d'un imageur selon l'invention.

Ces objets, caractéristiques et avantages ainsi que d'autres de la présente invention seront exposés plus en détail dans la description suivante du procédé selon l'invention, faite à titre non limitatif en relation avec les figures jointes parmi lesquelles :
- la figure 1 précédemment décrite représente un module de capture d'image pour appareil portatif,
- la figure 2 précédemment décrite est une vue en coupe schématique d'une microplaquette d'imageur,
- les figures 3A à 3E précédemment décrites illustrent un procédé de fabrication d'imageurs sur wafer de semi-conducteur,
- les figures 4A à 4D représentent des étapes de réalisation d'un filtre selon l'invention, et
- la figure 5 représente une microplaquette d'imageur selon l'invention.

Un exemple de mise en oeuvre du procédé selon l'invention sera décrit ici dans le cadre d'une fabrication d'imageurs sur wafer de semi-conducteur telle qu'illustrée sur les figures 3A à 3E précédemment décrites.

La présente invention prévoit de déposer plusieurs couches d'un matériau polymère durcissable sur le wafer fini 15' tel que représenté en figure 3A (c'est-à-dire le wafer 15' équipé des imageurs 10), avant le montage de la plaque de verre 20'.

Ces couches, et à tout le moins la dernière couche déposée avant montage de la plaque de verre 20', sont par exemple des couches de colles (époxy, uréthane, silicone....) ayant des indices optiques déterminés. Si nécessaire, des additifs, colorés ou non, sont ajoutés aux formules de colles standards afin d'obtenir des indices optiques déterminés. De façon générale, il est aisé à l'heure actuelle de se procurer tout type de colle ou autre matériau polymère défini par un cahier des charges précis spécifiant notamment la couleur et l'indice optique souhaités.

Les couches peuvent être réalisées avec le même matériau polymère mais contenant des additifs différents, ou avec des matériaux polymères différents, ou une combinaison de ces deux possibilités.

Dans l'art antérieur, la couche de colle 19' (fig. 3B) qui permet de fixer la plaque de verre 20' a sensiblement le même indice optique que le verre, de manière que sa présence ne provoque pas l'apparition de dioptres parasites. Les diverses couches de matériau polymère (ou de matériaux polymères) selon l'invention présentent au contraire des indices optiques distincts, afin que l'ensemble des couches forme un filtre optique multicouche.

Ces couches de matériau polymère sont de préférence déposées par enduction centrifuge ("spin coating"). Le matériau polymère peut être liquide ou gélatineux. Il est ensuite polymérisé suivant les conditions requises (polymérisation aux UV ou polymérisation thermique).

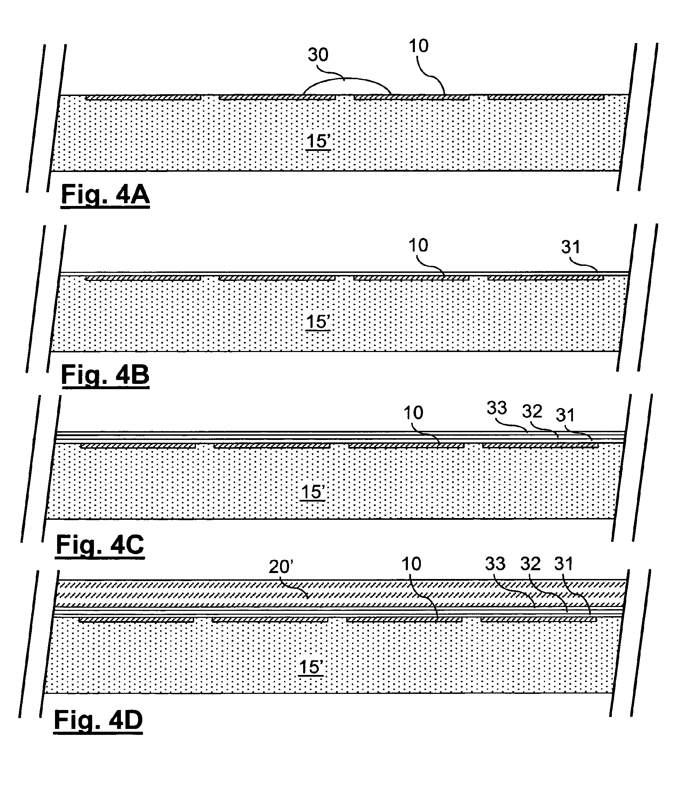

Ainsi, à l'étape représentée sur la figure 4A, une petite quantité de matériau polymère 30, de l'ordre de quelques millilitres, est déposée sur le wafer 15', de préférence au centre du wafer. A l'étape représentée sur la figure 4B, le matériau 30 est étalé sur toute la surface de la plaque de verre 20' par centrifugation. La vitesse de rotation du wafer est initialement assez faible, par exemple 1500 tr/min. Une forte accélération, par exemple jusqu'à 20000 tr/min, est ensuite appliquée au wafer pour favoriser la formation d'une couche uniforme 31 sur toute la surface de la plaque de verre tout en éliminant le surplus de matériau polymère. La vitesse de rotation est ensuite stabilisée à une valeur plus basse, par exemple de l'ordre de 2000 à 7000 tr/mn, afin de définir l'épaisseur de la couche 31. La rotation est encore maintenue un certain temps pour permettre l'évaporation du solvant. L'évaporation du solvant diminue sensiblement la viscosité du matériau polymère dont dépend l'épaisseur du film. L'évaporation étant rapide, il est nécessaire de veiller à ce que le délai d'étalement du matériau polymère soit court. Durant la rotation à grande vitesse, la plus grande partie du solvant contenu dans le matériau s'évapore pour finir par produire un film solide.

Une étape de cuisson est ensuite conduite. Cette étape assure l'élimination rapide des solvants résiduels et la polymérisation de la couche 31. Il s'ensuit une contraction (retrait volumique) du matériau polymère, qui engendre une perte d'épaisseur de l'ordre de la fraction de pourcent à quelques pourcents, selon le matériau utilisé.

Le wafer est par exemple chauffé au moyen de plaques chauffantes portées à une température de l'ordre de la centaine à quelques centaines de degrés (100-300°C en général). La durée du cycle de chauffage est ajustée pour atteindre le taux de solvant désiré, et peut être de quelques minutes à plus d'une heure. La cuisson est suivie d'une étape de refroidissement du wafer, par exemple au moyen de plaques à température ambiante.

Comme alternative, et selon le matériau retenu, l'étape de polymérisation peut également être conduite en exposant le wafer à un rayonnement UV. La polymérisation aux UV est généralement plus courte que la polymérisation thermique et ne dure que quelques minutes au maximum.

A l'étape illustrée sur la figure 4C, deux autres couches polymères 32, 33 ont été déposées sur la couche 31, la dernière couche 33 servant également de couche de colle pour l'étape de collage de la plaque de verre 20' représenté sur la figure 4D. On a ainsi réalisé, sous la plaque de verre 20', un filtre optique multicouche présentant une graduation d'indice optique.

L'homme de l'art notera que les couches polymères s'étendant sous la dernière couche (ici la couche 33) pourraient ne pas être des colles, et pourraient être par exemple des résines photosensibles (par exemple les résines "CT" utilisées pour la fabrication des microlentilles des imageurs) ou des résines "planarisantes" (résines utilisées pour former des surfaces planes en microélectronique), des résines de couleur, etc.

Egalement, l'invention n'exclut pas que la couche de colle 19' classique (fig. 2, fig. 3B) soit déposée sur le wafer avant le dépôt des couches 31 à 33 selon l'invention, pour planifier la surface du wafer au-dessus des microlentilles L0. La couche de colle 19' peut également être déposée sur les couches 31 à 33 afin d'assurer le collage de la plaque de verre. Dans ce cas, toutes les couches formant le filtre peuvent ne pas être des colles. Egalement, une couche de colle 19' ou une couche de planéité quelconque (couche "planarisante") peut être déposée sous les couches 31 à 33 et une couche de colle 19' être déposée sur les couches 31 à 33.

Dans une variante de réalisation, la couche 31 n'est pas polymérisée avant le dépôt de la couche 32 et la couche 32 n'est également pas polymérisée avant le dépôt de la couche 33. Les matériaux polymères formant les couches sont alors prévus miscibles (il peut s'agir du même matériau avec des additifs différents, comme indiqué plus haut) de sorte que la couche finale obtenue présente une variation progressive d'indice optique. Une étape de polymérisation finale est appliquée à l'ensemble des couches après leur dépôt. Si aucune couche de colle n'est ajoutée sur le filtre multicouche pour fixer la plaque de verre, cette polymérisation est faite après montage de la plaque de verre de manière que la structure multicouche assure le collage de la plaque de verre.

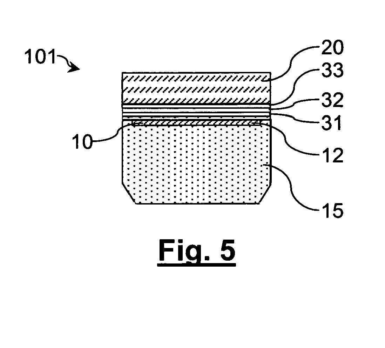

Comme représenté sur la figure 5, une microplaquette d'imageur 101 selon l'invention, obtenue par découpe du wafer, se distingue de la microplaquette classique 100 représentée sur la figure 2 par la présence des couches 31, 32, 33 formant filtre entre le silicium 15 et la microplaquette de verre 20.

Il apparaîtra clairement à l'homme de l'art que le procédé selon l'invention est susceptible de diverses applications et variantes de réalisation. Notamment le nombre de couches déposées pour former le filtre selon l'invention peut varier selon le filtre désiré (infrarouge, ultraviolet, etc..) et les matériaux polymères utilisés, l'exemple des trois couches 31 à 33 décrit plus haut n'étant aucunement limitatif.

Un filtre selon l'invention peut également ne comprendre qu'une seule couche, s'il est possible de réaliser une composition polymère offrant à elle seule toutes les propriétés optiques visées.

Le procédé selon l'invention permet ainsi de réaliser des modules de capture d'image embarqués dans des appareils portatifs tels des téléphones mobiles, des appareils photographiques, des caméras vidéo..., sans qu'il soit nécessaire d'agencer dans ces modules un filtre distinct des microplaquettes d'imageurs.

De plus, bien que le procédé selon l'invention ait été décrit dans ce qui précède en relation avec la fabrication d'un wafer de semi-conducteur comprenant une plaque de verre, un matériau transparent autre que du verre peut être utilisé, par exemple du plexiglas.

Le procédé selon l'invention est par ailleurs applicable à la réalisation de tous types de filtres optiques sur wafer destinés à laisser passer un rayonnement électromagnétique, dans le visible, l'infrarouge, l'ultraviolet voire au-delà, où à filtrer une bande de fréquences étroite ou large.

## Revendications

1. Procédé de fabrication de microplaquettes de semi-conducteur (100) comprenant chacune au moins un composant (10) implanté dans le semi-conducteur, comprenant :
- une étape d'implantation collective de composants (10) sur une face avant d'un wafer de semi-conducteur (15'), et
- une étape de fixation d'une plaque d'un matériau transparent (20') sur la face avant du wafer,
**caractérisé en ce que** l'étape de fixation de la plaque de matériau transparent (20') est précédée d'une étape de dépôt, sur la face avant du wafer, d'au moins une couche (31, 32, 33) d'un matériau polymère formant un filtre optique.

2. Procédé selon la revendication 1, dans lequel l'étape de fixation de la plaque de matériau transparent (20') est précédée d'une étape de dépôt, sur la face avant du wafer, de plusieurs couches (31, 32, 33) de matériau(x) polymère(s) formant ensemble un filtre optique multicouche.

3. Procédé selon l'une des revendications 1 et 2, dans lequel au moins la dernière couche (33) du filtre est une couche de colle assurant la fixation de la plaque de matériau transparent.

4. Procédé selon l'une des revendications 1 à 3, dans lequel toute couche (31, 32, 33) formant le filtre est une couche de colle.

5. Procédé selon l'une des revendications 1 et 2, comprenant une étape consistant à recouvrir le filtre optique par une couche de colle (19) assurant la fixation de la plaque de matériau transparent et n'intervenant pas dans la fonction de filtrage optique.

6. Procédé selon l'une des revendications 1 à 4 dans lequel le matériau polymère de chaque couche (31, 32, 33) du filtre est choisi dans le groupe comprenant les résines photosensibles, les résines planarisantes et les colles.

7. Procédé selon l'une des revendications 1 à 6, dans lequel chaque couche du filtre est polymérisée avant le dépôt de la couche suivante.

8. Procédé selon l'une des revendications 1 à 7, dans lequel au moins une couche du filtre n'est pas polymérisée avant le dépôt de la couche suivante, laquelle est miscible avec la couche non polymérisée, de manière à former une couche résultante à variation progressive d'indice optique qui est ensuite polymérisée.

9. Procédé selon l'une des revendications 1 à 8, dans lequel au moins une couche du filtre optique est déposée par enduction centrifuge.

10. Procédé selon l'une des revendications 1 à 9, comprenant une étape de découpe du wafer en microplaquettes individuelles.

11. Procédé selon l'une des revendications 1 à 10, dans lequel l'étape d'implantation de composants sur une face du wafer comprend l'implantation d'imageurs (10) destinés à capter des images par l'intermédiaire de la plaque de matériau transparent (20') et du filtre optique (31, 32, 33).

12. Procédé selon l'une des revendications 1 à 11, dans lequel la plaque de matériau transparent (20') est en verre.

13. Imageur (101) implanté sur une microplaquette de semi-conducteur (15), comprenant une microplaquette de matériau transparent (20) solidaire de la microplaquette de semi-conducteur et par l'intermédiaire de laquelle l'imageur reçoit des images à capter, **caractérisé en ce qu'**il comprend, entre la microplaquette de semi-conducteur (15) et la microplaquette de matériau transparent (20), au moins une couche (31, 32, 33) de matériau polymère formant un filtre optique.

14. Imageur selon la revendication 13, comprenant entre la microplaquette de semi-conducteur et la microplaquette de matériau transparent (20) plusieurs couches (31, 32, 33) de matériau(x) polymère(s) formant ensemble un filtre optique multicouche.

15. Imageur selon l'une des revendications 13 et 14, dans lequel le filtre optique est recouvert par une couche de colle (19) assurant la fixation de la plaque de matériau transparent et n'intervenant pas dans la fonction de filtrage optique.

16. Imageur selon l'une des revendications 13 et 14, dans lequel la dernière couche de matériau polymère (33) du filtre optique est une couche de colle assurant la fixation de la plaque de matériau transparent.

17. Imageur selon l'une des revendications 13, 14 et 16, dans lequel toute couche de matériau polymère (31, 32, 33) formant le filtre optique multicouche est une couche de colle.

18. Imageur selon l'une des revendications 13 à 17, dans lequel toute couche du filtre optique est formée par un matériau appartenant au groupe comprenant les résines photosensibles, les résines planarisantes et les colles.

19. Imageur selon l'une des revendications 13 à 18, dans lequel le filtre optique présente une graduation d'indice optique.

20. Imageur selon l'une des revendications 13 à 18, dans lequel le filtre optique multicouche présente une variation progressive d'indice optique.

21. Imageur selon l'une des revendications 13 à 20, dans lequel la microplaquette de matériau transparent est en verre.

22. Appareil portatif, **caractérisé en ce qu'**il comprend un module photographique ou vidéo équipé d'un imageur selon l'une des revendications 13 à 21.
